(19) Europäisches Patentamt

European Patent Office

Office européen des brevets

(11) **EP 1 346 140 B1**

(12) **EUROPÄISCHE PATENTSCHRIFT**

(45) Veröffentlichungstag und Bekanntmachung des Hinweises auf die Patenterteilung:
**21.09.2005 Patentblatt 2005/38**

(21) Anmeldenummer: **01995610.1**

(22) Anmeldetag: **17.12.2001**

(51) Int Cl.⁷: $F02D\ 41/20$, $H01L\ 41/04$

(86) Internationale Anmeldenummer:
**PCT/DE2001/004742**

(87) Internationale Veröffentlichungsnummer:
**WO 2002/050413 (27.06.2002 Gazette 2002/26)**

(54) **AKTORSTEUERUNG UND ZUGEHÖRIGES VERFAHREN**

ACTUATOR REGULATION AND CORRESPONDING METHOD

REGULATION D'ACTIONNEUR ET PROCEDE ASSOCIE

(84) Benannte Vertragsstaaten:
**DE FR IT**

(30) Priorität: **18.12.2000 DE 10063080**

(43) Veröffentlichungstag der Anmeldung:
**24.09.2003 Patentblatt 2003/39**

(73) Patentinhaber: **SIEMENS AKTIENGESELLSCHAFT**
**80333 München (DE)**

(72) Erfinder:
• **BARANOWSKI, Dirk**
 **93059 Regensburg (DE)**

• **HOFFMANN, Christian**
 **93057 Regensburg (DE)**
• **PIRKL, Richard**
 **93047 Regensburg (DE)**
• **BOCK, Wolfgang**
 **93055 Regensburg (DE)**

(56) Entgegenhaltungen:
**WO-A-00/19549        DE-A- 19 805 184**
**DE-A- 19 848 950        DE-C- 19 652 801**
**DE-C- 19 652 809        DE-C- 19 723 932**

EP 1 346 140 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft ein Verfahren zur Einstellung eines vorgegebenen Hubs eines Aktors, insbesondere eines piezoelektrischen Aktors für einen Injektor einer Einspritzanlage, gemäss dem Oberbegriff des Anspruchs 1 sowie eine Aktorsteuerung gemäss dem Oberbegriff des Anspruchs 3 zur Durchführung eines derartigen Verfahrens.

In Einspritzanlagen von Brennkraftmaschinen erfolgt die Einspritzung von Kraftstoff in die Brennräume der Brennkraftmaschine durch Injektoren, wobei der Einspritzvorgang durch piezoelektrische Aktoren gesteuert wird, die eine Düsenöffnung in Abhängigkeit von ihrer elektrischen Ansteuerung entweder freigeben oder verschliessen. Für einen ordnungsgemässen Betrieb des Injektors muss der piezoelektrische Aktor deshalb einen konstanten Hub erreichen. Zur Einstellung des vorgegebenen Aktorhubs wird in verschiedenen Patentanmeldungen, wie beispielsweise DE 197 23 932, DE 196 52 809 und DE 196 52 801 die physikalische Erkenntnis ausgenutzt, dass sich der Aktorhub im wesentlichen proportional zu der zugeführten elektrischen Energie verhält. Bei der Ansteuerung des Aktors wird deshalb die zugeführte elektrische Ladung und die daraus resultierende elektrische Spannung gemessen, um daraus die zugeführte elektrische Energie zu berechnen.

Nachteilig an der vorstehend beschriebenen bekannten Aktorsteuerung ist die Tatsache, dass der funktionale Zusammenhang zwischen der dem Aktor zugeführten elektrischen Energie und dem daraus resultierenden Aktorhub temperaturabhängig ist, was bei einem Einsatz in einem PKW aufgrund der im Betrieb auftretenden grossen Temperaturschwankungen zu Abweichungen des Aktorhubs von dem vorgegebenen Sollwert führt.

Aus JP64-069756AA ist eine Aktorsteuerung für eine Einspritzanlage bekannt, die einen Temperatursensor aufweist, wobei der Aktor mit einer temperaturabhängigen Spannung beaufschlagt wird.

Des Weiteren ist aus DE 198 48 950 A1 eine Vorrichtung zur Kontaktansteuerung piezoelektrischer Aktuatoren für Kraftstoffeinspritzsysteme bekannt, bei der aufgrund der Kapazität des Aktors über eine vorgegebene Kapazitätstemperaturkennlinie die Aktortemperatur bestimmt wird.

Aus WE 00/19549 ist ein Verfahren und eine Anordnung zur Diagnose eines kapazitiven Aktors bekannt, die eine Funktionsprüfung eines Temperatursensors vorsieht.

Weiterhin ist aus DE 198 05 184 A1 eine Aktorsteuerung bekannt, die keinen separaten Temperatursensor benötigt, da die Temperatur des Aktors entsprechend einer bekannten Kennlinie aus der Kapazität des Aktors ermittelt wird.

Darüber hinaus ist aus DE 197 23 932 Cl eine Aktorsteuerung bekannt, bei der die Ladeenergie des Aktors geregelt wird, um den Einfluß von Temperaturschwankungen auf das Stellverhalten des Aktors möglichst gering zu halten.

Schließlich ist aus JP05344755AA eine Aktorsteuerung bekannt, bei der dem Aktor eine vorgegebene elektrische Ladung zugeführt wird, wobei während der Entladung des Aktors die Kapazität des Aktors gemessen und die negative Spannung entsprechend geregelt wird, um Temperaturschwankungen auszugleichen.

Der Erfindung liegt deshalb die Aufgabe zugrunde, die vorstehend beschriebene bekannte Aktorsteuerung dahingehend zu verbessern, dass der Aktorhub temperaturunabhängig möglichst genau eingestellt werden kann, ohne dass ein zusätzlicher Temperatursensor erforderlich ist.

Die Aufgabe wird, ausgehend von dem eingangs beschriebenen bekannten Verfahren zur Einstellung eines vorgegebenen Hubs gemäss dem Oberbegriff des Anspruchs 1, durch die kennzeichnenden Merkmale des Anspruchs 1 bzw. - hinsichtlich einer entsprechenden Aktorsteuerung - durch die Merkmale des Anspruchs 3 gelöst.

Erfindungsgemäß wird die Temperatur des Aktors bei dessen elektrischer Ansteuerung berücksichtigt, ohne dass ein Temperatursensor erforderlich ist. Hierbei wird von zwei bekannten und zuvor ausgemessenen aktorspezifischen Kennlinien ausgegangen. Die eine Kennlinie gibt hierbei - wie bereits zuvor erwähnt - die auf den Aktor zur Erreichung eines vorgegebenen Hubs aufzubringende elektrische Ladung als Funktion der Temperatur an. Die andere Kennlinie gibt dagegen die zur Erreichung eines vorgegebenen Hubs erforderliche elektrische Spannung des Aktors als Funktion der Temperatur wieder. Zur Erreichung eines vorgegebenen Hubs müssten sich also sowohl Spannung als auch Ladung entsprechend den vorgegebenen Kennlinien verhalten, so dass sich aus Spannung und Ladung eine temperaturunabhängige Führungsgrösse berechnen lässt, die zur Regelung der auf den Aktor aufzubringenden elektrischen Ladung herangezogen wird. Die Regelung der Aktorladung erfolgt vorzugsweise so, dass die temperaturunabhängige Führungsgrösse einen konstanten Wert annimmt. Vorteilhaft an dieser Variante der Erfindung ist insbesondere, dass kein separater Temperatursensor erforderlich ist.

Ahstelle der vorstehend beschriebenen indirekten Messung der Aktortemperatur kann die Aktortemperatur jedoch auch direkt gemessen werden, indem beispielsweise ein Temperatursensor an dem Aktor angebracht wird. Statt dessen kann die Aktortemperatur auch durch Messung der temperaturabhängigen Kapazität des Aktors bestimmt werden, indem der Messwert der Kapazität anschließend mit der bekannten und zuvor ausgemessenen temperaturabhängigen Kapazitätskennlinie des Aktors verglichen wird.

Bei der temperaturabhängigen elektrischen Ansteuerung des Aktors wird vorzugsweise von einer bekannten temperaturabhängigen Kennlinie ausgegangen, welche die dem Aktor zur Erreichung eines konstanten Hubs zuzuführende elektrische Ladung in Abhängigkeit von der Temperatur wiedergibt. Entsprechend dieser Kennlinie wird dann aus der gemessenen Aktortemperatur die erforderliche elektrische Ladung ermittelt und der Aktor entsprechend angesteuert. Auf diese Weise wird vorteilhaft sichergestellt, dass der Aktorhub unabhängig von der Aktortemperatur konstant ist.

In einer vorteilhaften Ausführungsform dieser Variante der Erfindung wird auch die elektrische Spannung des Aktors gemessen, um die Richtigkeit der Temperaturmessung zu überprüfen. Zusätzlich zu dem Messwert der elektrischen Spannung des Aktors wird hierzu eine theoretischer Wert der elektrischen Spannung des Aktors berechnet, der sich entsprechend einer vorgegebenen aktorspezifischen temperaturabhängigen Spannungskennlinie aus der gemessenen Aktortemperatur ergibt. Bei einer korrekten Temperaturmessung muss der Messwert der Aktorspannung im wesentlichen gleich dem theoretisch berechneten Spannungswert sein, der sich aus der Aktortemperatur und der Spannungskennlinie des Aktors ergibt. Bei einer Abweichung des Spannungsmesswertes von dem theoretisch berechneten Spannungswert liegt vermutlich ein Fehler vor. Bei dieser Ausführungsform wird also zunächst die Aktortemperatur gemessen bzw. aus einem oder mehreren Messwert abgeleitet. Bei der gemessenen Aktortemperatur werden dann die elektrischen Kenngrößen Ladung und Spannung des Aktors ermittelt, um daraufhin die als Ansteuergröße verwendete Ladung des Aktors so nachzuführen, dass der Aktorhub konstant ist. Hierbei werden dann ebenfalls Ladung und Spannung des Aktors gemessen, um daraus die Aktortemperatur zu bestimmen und mit dem Messwert der Aktortemperatur zu vergleichen.

In einer anderen Variante der Erfindung wird die Temperatur des Aktors bei dessen elektrischer Ansteuerung berücksichtigt, ohne dass ein Temperatursensor erforderlich ist. Hierbei wird von zwei bekannten und zuvor ausgemessenen aktorspezifischen Kennlinien ausgegangen. Die eine Kennlinie gibt hierbei - wie bereits zuvor erwähnt - die auf den Aktor zur Erreichung eines vorgegebenen Hubs aufzubringende elektrische Ladung als Funktion der Temperatur an. Die andere Kennlinie gibt dagegen die zur Erreichung eines vorgegebenen Hubs erforderliche elektrische Spannung des Aktors als Funktion der Temperatur wieder. Zur Erreichung eines vorgegebenen Hubs müssten sich also sowohl Spannung als auch Ladung entsprechend den vorgegebenen Kennlinien verhalten, so dass sich aus Spannung und Ladung eine temperaturunabhängige Führungsgröße berechnen lässt, die zur Regelung der auf den Aktor aufzubringenden elektrischen Ladung herangezogen wird. Die Regelung der Aktorladung erfolgt vorzugsweise so, dass die temperaturunabhängige Führungsgröße einen konstanten Wert annimmt. Vorteilhaft an dieser Variante der Erfindung ist insbesondere, dass kein separater Temperatursensor erforderlich ist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:

Figur 1a    eine Aktorsteuerung mit einem separaten Temperatursensor, gemäß dem Stand der Technik

Figur 1b    das Betriebsverfahren der in Figur 1a dargestellten Aktorsteuerung als Flussdiagramm,

Figur 2a    eine erfindungsgemäße Aktorsteuerung ohne einen separaten Temperatursensor,

Figur 2b    das Betriebsverfahren der in Figur 2a dargestellten Aktorsteuerung als Flussdiagramm und

Figur 3    zwei aktorspezifische Kennlinien.

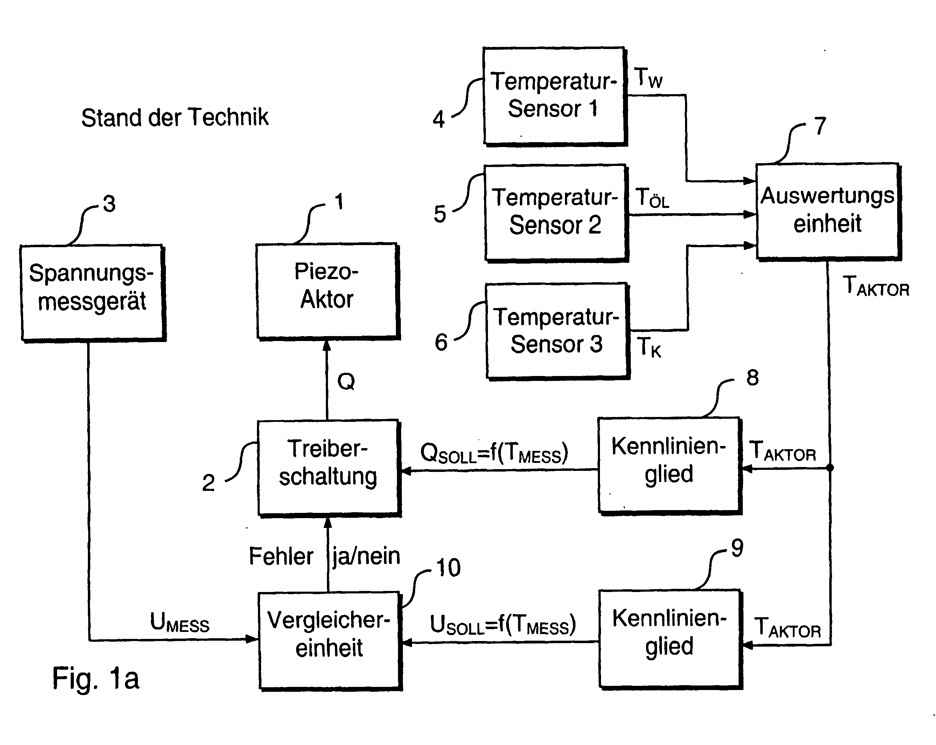

Die in Figur 1a als Blockschaltbild dargestellte Aktorsteuerung dient zur Ansteuerung eines piezoelektrischen Aktors 1, der in einem Injektor einer Einspritzanlage für eine Brennkraftmaschine verwendet wird. Ziel der Ansteuerung des Aktors 1 ist hierbei die Einstellung eines vorgegebenen konstanten Hubs, wie noch detailliert erläutert wird.

Die elektrische Ansteuerung des Aktors 1 erfolgt durch eine Treiberschaltung 2, die eine vorgegebene elektrische Ladung $Q$ auf den Aktor 1 gibt. Entsprechend der elektrischen Ladung $Q$ des Aktors 1 stellt sich dann eine elektrische Spannung $U$ an dem Aktor 1 ein, die von einem Spannungsmessgerät 3 gemessen wird. Hierbei wird die physikalische Erkenntnis ausgenutzt, dass der Hub des Aktors 1 im wesentlichen von der auf den Aktor 1 aufgebrachten elektrischen Energie bestimmt wird, wobei sich die elektrische Energie als Produkt aus Ladung $Q$ und Spannung $U$ ergibt.

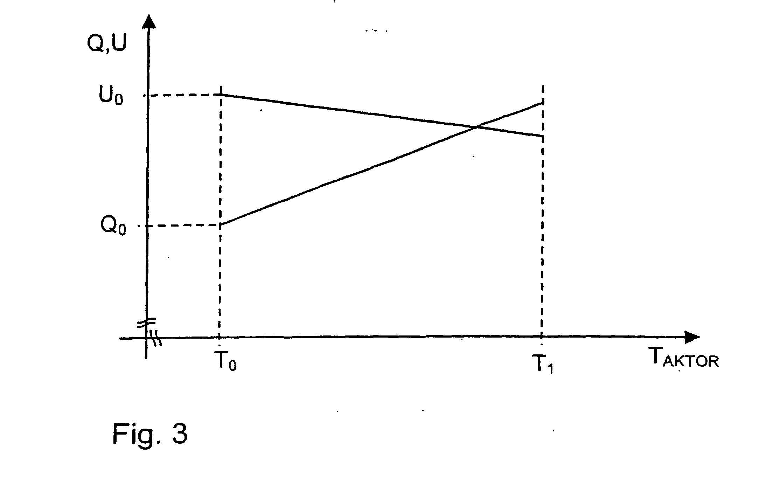

Der funktionale Zusammenhang zwischen der auf den Aktor 1 aufgebrachten elektrischen Energie und dem Hub des Aktors 1 ist jedoch auch temperaturabhängig, so dass die Temperatur bei der Ansteuerung des Aktors 1 berücksichtigt wird, um temperaturbedingte Schwankungen des Aktorhubs zu vermeiden. Hierzu weist die Aktorsteuerung drei Temperatursensoren 4, 5, 6 auf, welche die Kühlwassertemperatur $T_W$, die Öltemperatur $T_{ÖL}$ bzw. die Kraftstofftemperatur $T_K$ messen und an eine Auswertungseinheit 7 weiterleiten, die daraus die Aktortemperatur $T_{AKTOR}$ ableitet. Ausgangsseitig ist die Auswertungseinheit 7 mit zwei Kennliniengliedern 8, 9 verbunden, die aus der Aktortemperatur $T_{AKTOR}$ die zur Erreichung des vorgegebenen Hubs erforderliche elektrische Ladung $Q_{SOLL}$ bzw. die elektrische Spannung $U_{SOLL}$ ermitteln. Hierbei wird der in Figur 3 dargestellte funktionale Zusammenhang zwischen der Aktortemperatur $T_{AKTOR}$ und der erforderlichen Ladung Q bzw. der erforderlichen Spannung U ausgenutzt. Das Kennlinienglied 8 gibt also der Treiberschaltung 2 den Sollwert $Q_{SOLL}$ für die auf den Aktor 1 aufzubringende elektrische Ladung in Abhängigkeit von der Aktortemperatur $T_{AKTOR}$ vor, so dass unabhängig von der Aktortemperatur $T_{AKTOR}$ ein konstanter Hub eingestellt wird.

Darüber hinaus überprüft die Aktorsteuerung die Richtigkeit der Temperaturmessung, indem der von dem Spannungsmessgerät 3 gemessene Spannungswert $U_{MESS}$ mit dem von dem Kennlinienglied 9 ermittelten Spannungssollwert $U_{SOLL}$ durch eine Vergleichereinheit 10 verglichen wird. Bei einer korrekten Temperaturbestimmung durch die Temperatursensoren 4-6, die Auswertungseinheit 7 und das Kennlinienglied 9 muss der Messwert $U_{MESS}$ im wesentlichen gleich dem theoretisch berechneten Wert $U_{SOLL}$ sein. Das Ergebnis der Überprüfung leitet die Vergleichereinheit 10 als Fehlersignal an die Treiberschaltung 2 weiter.

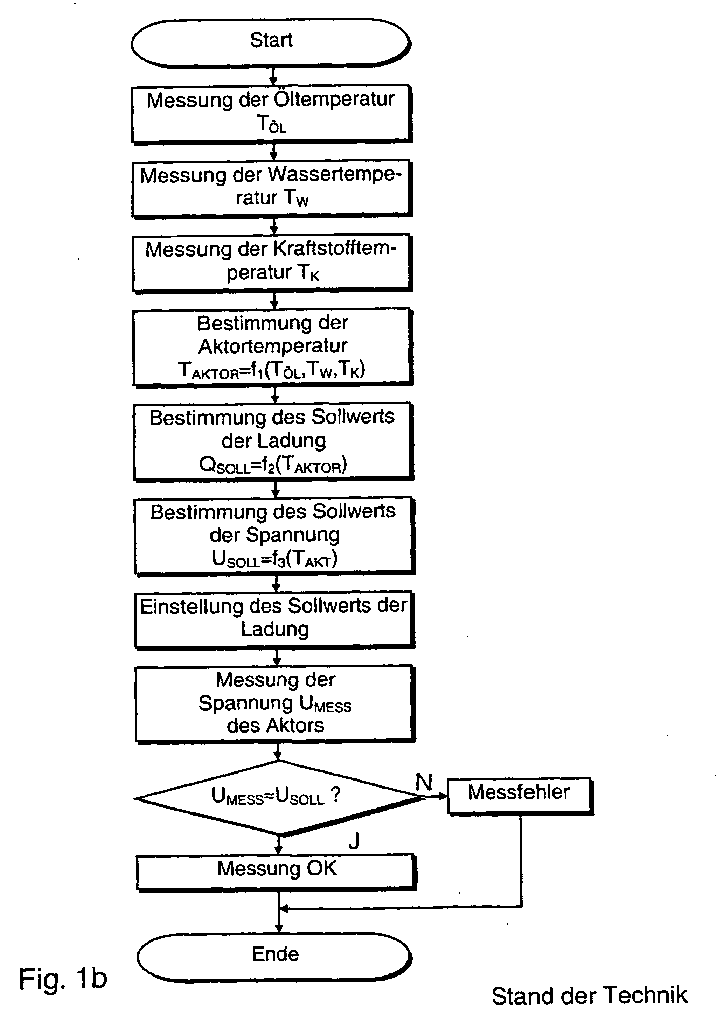

Im folgenden wird nun unter Bezugnahme auf das in Figur 1b dargestellte Flussdiagramm das Betriebsverfahren der in Figur la dargestellten Aktorsteuerung kurz erläutert.

Zunächst wird die Öltemperatur $T_{ÖL}$, die Wassertemperatur $T_W$ und die Kraftstofftemperatur $T_K$ gemessen, um daraus in einem nächsten Schritt die Aktortemperatur $T_{AKTOR}=f_1(T_{ÖL}, T_W, T_K)$ zu bestimmen. Anschließend ordnet das Kennlinienglied 8 der gemessenen Aktortemperatur $T_{AKT}$ einen Sollwert für die auf den Aktor 1 aufzubringende elektrische Ladung $Q_{SOLL}$ zu.

Weiterhin ermittelt das Kennlinienglied 9 in Abhängigkeit von der gemessenen Aktortemperatur $T_{AKT}$ den theoretisch berechneten Sollwert für die elektrische Spannung $U_{SOLL}$ des Aktors 1, die sich ergeben muss, wenn die zuvor als Sollwert bestimmte elektrische Ladung $Q_{SOLL}$ auf den Aktor 1 gebracht wurde.

Danach steuert die Treiberschaltung 2 den Aktor 1 so an, dass die Ladung des Aktors 1 gleich dem vorgegebenen Sollwert ist.

Daraufhin wird die Spannung $U_{MESS}$ des Aktors 1 gemessen und mit dem theoretisch berechneten Wert $U_{SOLL}$ verglichen, wobei im Falle einer Abweichung von $U_{MESS}$ und $U_{SOLL}$ ein Messfehler angenommen wird, was eine Kalibrierung der gemessenen Spannung $U_{MESS}$ ermöglicht.

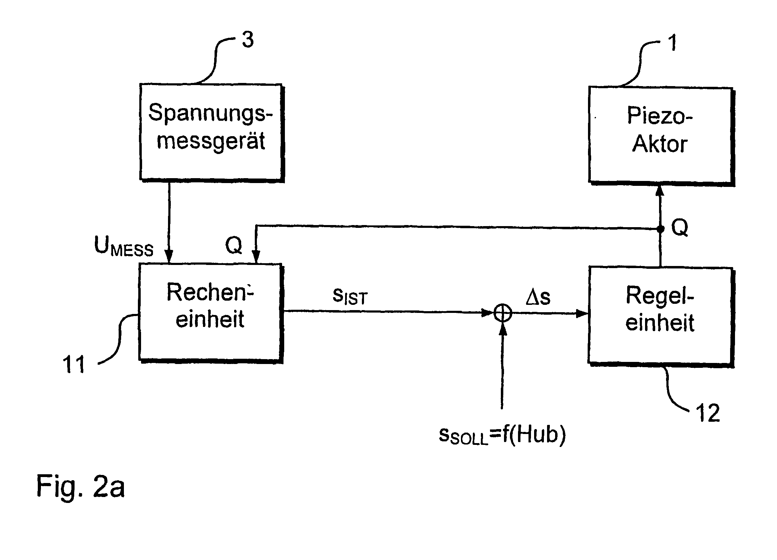

Das in Figur 2a dargestellte alternative Ausführungsbeispiel einer erfindungsgemäßen Aktorsteuerung ermöglicht vorteilhaft die Berücksichtigung der Aktortemperatur bei der Ansteuerung des Aktors 1, ohne dass ein separater Temperatursensor erforderlich ist. Hierbei werden ebenfalls die in Figur 3 dargestellten bekannten Kennlinien des Aktors 1 ausgenutzt, die den funktionalen Zusammenhang zwischen der zur Erreichung eines vorgegebenen Hubs erforderlichen Ladung Q bzw. Spannung U des Aktors 1 und der Aktortemperatur $T_{AKTOR}$ wiedergeben. Die elektrische Ladung Q des Aktors 1 und die von dem Spannungsmessgerät 3 gemessene elektrische Spannung $U_{MESS}$ des Aktors 1 werden deshalb einer Recheneinheit 11 zugeführt, die aus der Ladung Q und der Spannung $U_{MESS}$ des Aktors 1 eine temperaturunabhängige Führungsgröße s berechnet und einer Regeleinheit 12 zuführt, welche die elektrische Ladung Q des Aktors 1 in Abhängigkeit von der Führungsgröße s regelt, wobei die Führungsgröße s den gewünschten Hub bestimmt.

In der Regel sind die in Figur 3 dargestellten temperaturabhängigen Kennlinien annähernd linear, so dass gilt:

$$U_{SOLL} = U_0 + b \cdot (T - T_0)$$

$$Q_{SOLL} = Q_0 + a \cdot (T - T_0)$$

Aus diesen beiden Formeln für die Ladung Q und die Spannung U ergibt sich dann eine temperaturunabhängige Führungsgröße s wie folgt:

$$Q = Q_0 + a \cdot \frac{U - U_0}{b}$$

$$\Rightarrow Q - \frac{a}{b} \cdot U = Q_0 + \frac{a}{b} \cdot U_0$$

$$\Rightarrow s = Q - \frac{a}{b} \cdot U = Q_0 + \frac{a}{b} \cdot U_0 = const.$$

Der Aktorhub ist also konstant, wenn die Führungsgröße s auf einen konstanten Wert geregelt wird, wobei der Wert der Führungsgröße s den Hub des Aktors 1 bestimmt.

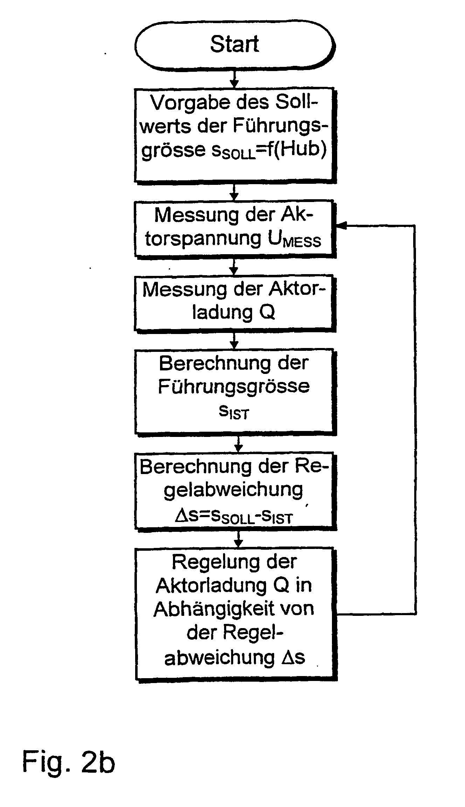

Im folgenden wird nun unter Bezugnahme auf das in Figur 2b dargestellte Flussdiagramm das Betriebsverfahren der in Figur 2a dargestellten Aktorsteuerung erläutert.

Zu Beginn wird zunächst der Sollwert $s_{SOLL}$ der Führungsgröße s vorgegeben, der den Hub bestimmt.

Anschließend wird dann in einer Regelschleife die Aktorspannung $U_{MESS}$ und die Aktorladung U gemessen und daraus der aktuelle Wert der Führungsgröße s berechnet. Anschließend wird dann die Regelabweichung als Differenz zwischen dem Sollwert $s_{SOLL}$ der Führungsgröße und dem berechneten Wert der Führungsgröße ermittelt. Anschließend erfolgt dann kontinuierlich oder stufenweise eine Regelung der Aktorladung Q in Abhängigkeit von der Regelabweichung $\Delta s$.

Die Erfindung ist nicht auf die vorstehend beschriebenen Ausführungsbeispiele beschränkt. Vielmehr ist eine Vielzahl von Varianten und Abwandlungen denkbar.

**Patentansprüche**

1. Verfahren zur Einstellung eines vorgegebenen Hubs eines Aktors (1), insbesondere eines piezoelektrischen Aktors (1) für einen Injektor einer Einspritzanlage,
bei dem eine erste elektrische Zustandsgrösse (Q) des Aktors (1) eingestellt wird, die den Hub des Aktors (1) bestimmt,
wobei die erste elektrische Zustandsgrösse (Q) in Abhängigkeit von der Temperatur ($T_{AKTOR}$) des Aktors (1) eingestellt wird, um temperaturbedingte Schwankungen des Aktorhubs zu vermeiden,
wobei eine zweite elektrische Zustandsgrösse (U) des Aktors (1) gemessen und aus der ersten elektrischen Zustandsgrösse (Q) und der zweiten elektrischen Zustandsgrösse (U) eine Führungsgrösse (s) berechnet wird, die unabhängig von der Temperatur ($T_{AKTOR}$) des Aktors (1) einem vorgegebenen Hub des Aktors (1) entspricht, wobei die erste elektrische Zustandsgrösse (Q) in Abhängigkeit von der Führungsgrösse (s) geregelt wird,
**dadurch gekennzeichnet,**
**dass** die Führungsgröße (s) ausgehend von einer bekannten temperaturabhängigen Kennlinie für die erste elektrische Zustandsgröße (Q) und einer bekannten temperaturabhängigen Kennlinie für die zweite Zustandsgröße (U) berechnet wird, so dass sich sowohl die erste elektrische Zustandsgröße (Q) als auch die zweite elektrische Zustandsgröße (U) entsprechend den vorgegebenen Kennlinien verhalten.

2. Verfahren nach Anspruch 1, **dadurch gekennzeichnet, dass** die erste elektrische Zustandsgrösse (Q) die elektrische Ladung des Aktors (1) ist.

3. Verfahren nach einem der Ansprüche 1 oder 2, **dadurch gekennzeichnet, dass** die zweite elektrische Zustandsgröße (U) des Aktors (1) die elektrische Spannung des Aktors (1) ist.

4. Aktorsteuerung, insbesondere zur Ansteuerung eines piezoelektrischen Aktors (1) einer Einspritzanlage für eine Brennkraftmaschine, mit

einer Treiberschaltung (2) zur Einstellung einer ersten elektrischen Zustandsgrösse (Q) des Aktors (1), wobei die erste elektrische Zustandsgrösse (Q) den Hub des Aktors (1) bestimmt,

einer Steuer- bzw. Regeleinheit zur Einstellung der ersten elektrischen Zustandsgrösse (Q) in Abhängigkeit von der Temperatur ($T_{AKTOR}$) des Aktors (1),

wobei zur Messung einer zweiten elektrischen Zustandsgrösse (U) des Aktors (1) ein elektrisches Messgerät (3) vorgesehen ist, das ausgangsseitig mit einer Recheneinheit (11) verbunden ist, die aus der ersten elektrischen Zustandsgrösse (Q) und der zweiten elektrischen Zustandsgrösse (U) eine Führungsgrösse (s) für eine Regeleinheit (12) berechnet, wobei die Regeleinheit (12) die erste elektrische Zustandsgrösse (Q) in Abhängigkeit von der Führungsgrösse (s) regelt,
**dadurch gekennzeichnet,**
**dass** die Recheneinheit die Führungsgröße (s) ausgehend von einer bekannten temperaturabhängigen Kennlinie für die erste elektrische Zustandsgröße (Q) und einer bekannten temperaturabhängigen Kennlinie für die zweite Zustandsgröße (U) berechnet, so dass sich sowohl die erste elektrische Zustandsgröße (Q) als auch die zweite elektrische Zustandsgröße (U) entsprechend den vorgegebenen Kennlinien verhalten.

5. Aktorsteuerung nach Anspruch 4, **dadurch gekennzeichnet, dass** die erste elektrische Zustandsgröße (Q) die elektrische Ladung des Aktors (1) ist.

6. Aktorsteuerung nach einem der vorhergehenden Ansprüche, **dadurch gekennzeichnet, dass** die zweite elektrische Zustandsgröße (U) des Aktors (1) die elektrische Spannung des Aktors (1) ist.

**Claims**

1. Method for setting a predetermined travel of an actuator (1), in particular a piezo-electric actuator (1) for an injector of an injection system,
in which a first electrical state variable (Q) of the actuator (1) is set, which determines the travel of the actuator (1),
in which the first electrical state variable (Q) is set as a function of the temperature ($T_{AKTOR}$) of the actuator (1) to avoid temperature-induced fluctuations of the actuator travel,
in which a second electrical state variable (U) of the actuator (1) is measured and a reference variable (s) is determined from the first electrical state variable (Q) and the second electrical state variable (U), which corresponds to a predetermined travel of the actuator (1) independent of the temperature ($T_{AKTOR}$) of the actuator (1), the first electrical state variable (Q) being regulated as a function of the reference variable (s),
**characterised in that**,
the reference variable (s) is calculated on the basis of a known temperature dependent characteristic curve for the first electrical state variable (Q) and a known temperature dependent characteristic curve for the second state variable (U), so that both the first electrical state variable (Q) and also the second electrical state variable (U) behave according to the predetermined characteristic curve.

**2.** Method according to claim 1, **characterised in that** the first electrical state variable (Q) is the electrical loading of the actuator (1).

**3.** Method according to claim 1 or 2, **characterised in that** the second electrical state variable (U) of the actuator (1) is the electrical voltage of the actuator (1).

**4.** Actuator regulation, in particular for regulating a piezo-electric actuator (1) of an injection system for an internal combustion engine, with

a drive circuit (2) for setting a first electrical state variable (Q) of the actuator (1), with the first electrical state variable (Q) determining the travel of the actuator (1),

a control or regulation unit for setting the first electrical state variable (Q) in accordance with the temperature ($T_{AKTOR}$) of the actuator (1)

in which an electrical measurement device (3) is provided in order to measure a second electrical state variable (U) of the actuator (1), said electrical measurement device being connected to a computing unit (11) on the outlet side, said computing unit calculating a reference variable (s) for a regulation unit (12) from the first electrical reference parameter (Q) and the second electrical reference parameter (U), the regulation unit (12) regulating the first electrical reference variable (Q) as a function of the reference parameter (s),
**characterised in that**,
the computing unit calculates the reference variable (s) based on a known temperature-dependent characteristic curve for the first electrical state variable (Q) and a known temperature-dependent characteristic curve for the second state variable (U) so that both the first electrical state variable (Q) and the second electrical state variable (U) behave correspondingly to the predetermined characteristic curves.

**5.** Actuator regulation according to claim 4, **characterised in that** the first electrical state variable (Q) is the electrical loading of the actuator (1).

**6.** Actuator regulation according to one of the preceding claims, **characterised in that**, the second electrical state variable (U) of the actuator (1) is the electrical voltage of the actuator 1.

**Revendications**

**1.** Procédé pour le réglage d'une course prédéterminée d'un actionneur (1), en particulier d'un actionneur piézoélectrique (1) pour un injecteur d'une installation d'injection,

dans lequel on règle une première grandeur d'état électrique (Q) de l'actionneur (1) qui détermine la course de l'actionneur(1),

où on règle la première grandeur d'état électrique (Q) en fonction de la température ($T_{AKTOR}$) de l'actionneur (1) pour éviter les fluctuations de la course de l'actionneur dues à la température,

où on mesure une seconde grandeur d'état électrique (U) de l'actionneur (1) et, sur la base de la première grandeur d'état électrique (Q) et de la seconde grandeur d'état électrique (U), on calcule une grandeur guide (s) qui correspond à une course prédéterminée de l'actionneur (1), indépendamment de la température ($T_{AKTOR}$) de l'actionneur (1), la première grandeur d'état électrique (Q) étant réglée en fonction de la grandeur guide (s),
**caractérisé en ce que**
la grandeur guide (s) est calculée en partant d'une courbe caractéristique connue ,fonction de la température, de la première grandeur d'état électrique (Q) et d'une courbe caractéristique connue, fonction de la température, de la seconde grandeur d'état électrique (U), de manière qu'aussi bien la première grandeur d'état électrique (Q) que la seconde grandeur d'état électrique (U) se comportent conformément aux courbes caractéristiques prédéterminées.

**2.** Procédé selon la revendication 1,
**caractérisé en ce que**
la première grandeur d'état électrique (Q) est la charge électrique de l'actionneur (1).

**3.** Procédé selon une des revendications 1 ou 2,
**caractérisé en ce que** la seconde grandeur d'état électrique (U) de l'actionneur (1) est la tension électrique de l'actionneur (1).

**4.** Commande d'actionneur , en particulier pour la commande d'un actionneur piézoélectrique (1) d'une installation d'injection pour un moteur à combustion interne, comprenant

un circuit d'attaque (2) destiné à régler une première grandeur d'état électrique (Q) de l'actionneur (1), laquelle première grandeur d'état électrique (Q) détermine la course de l'actionneur (1),

une unité de commande ou de régulation destinée à régler la première grandeur d'état électrique (Q) en fonction de la température ($T_{AKTOR}$) de l'actionneur (1),

dans laquelle il est prévu, pour la mesure d'une seconde grandeur d'état électrique (U) de l'actionneur (1), un appareil de mesure électrique (3) qui est relié, côté sortie à une unité de calcul (11) qui calcule, à partir de la première grandeur d'état électrique (Q) et de la seconde grandeur d'état électrique (U), une grandeur guide (s) pour une unité de régulation (12), l'unité de régulation (12) réglant alors la première grandeur d'état électrique (Q) en fonction de la grandeur guide (s),

**caractérisée en ce que**

l'unité de calcul calcule la grandeur guide (s) sur la base d'une courbe caractéristique connue, fonction de la température, de la première grandeur d'état électrique (Q) et d'une courbe caractéristique connue, fonction de la température, de la seconde grandeur d'état électrique (U), de telle manière qu'aussi bien la première grandeur d'état électrique (Q) que la seconde grandeur d'état électrique (U) se comportent conformément aux courbes caractéristiques prédéterminées.

5. Commande d'actionneur selon la revendication 4, **caractérisée en ce que** la première grandeur d'état électrique (Q) est la charge électrique de l'actionneur(1).

6. Commande d'actionneur selon une des revendications précédentes,
**caractérisée en ce que** la seconde grandeur d'état électrique (U) de l'actionneur (1) est la tension électrique de l'actionneur (1).

Stand der Technik

Fig. 1a

EP 1 346 140 B1

Start

Messung der Öltemperatur $T_{ÖL}$

Messung der Wassertemperatur $T_W$

Messung der Kraftstofftemperatur $T_K$

Bestimmung der Aktortemperatur $T_{AKTOR}=f_1(T_{ÖL},T_W,T_K)$

Bestimmung des Sollwerts der Ladung $Q_{SOLL}=f_2(T_{AKTOR})$

Bestimmung des Sollwerts der Spannung $U_{SOLL}=f_3(T_{AKT})$

Einstellung des Sollwerts der Ladung

Messung der Spannung $U_{MESS}$ des Aktors

$U_{MESS}{\approx}U_{SOLL}$ ?

N → Messfehler

J

Messung OK

Ende

Fig. 1b

Stand der Technik

Fig. 2a

Fig. 2b

Fig. 3